# EUROPEAN PATENT SPECIFICATION

(11) **EP 3 379 551 B1**
(45) Date of publication and mention of the grant of the patent: **15.10.2025**
(21) Application number: 16865933.2
(22) Date of filing: 16.11.2016
(51) Int. Cl.: H01M 14/00, H10K 30/00, H10K 39/30, H10K 85/50, H01G 9/20

(54) **PHOTOELECTRIC CONVERSION DEVICE**
VORRICHTUNG ZUR FOTOELEKTRISCHEN UMWANDLUNG
DISPOSITIF DE CONVERSION PHOTOÉLECTRIQUE

(30) Priority: 17.11.2015 JP 2015224403
(43) Date of publication of application: 26.09.2018
(73) Proprietor: National University Corporation Tokai National Higher Education and Research System, Nagoya-shi, Aichi 464-8601 (JP); Nisshinbo Holdings Inc., Tokyo 103-8650 (JP)
(72) Inventor: AWAGA, Kunio, Nagoya-shi Aichi 464-8601 (JP); MATSUSHITA, Michio, Nagoya-shi Aichi 464-8601 (JP); KARAK, Supravat, Nagoya-shi Aichi 464-8601 (JP); YUYAMA, Kanako, Chiba-shi Chiba 267-0056 (JP)
(74) Representative: TBK
(86) International application number: PCT/JP2016/004890
(87) International publication number: WO 2017/085929

(56) References cited:
- EP-A1- 1 596 460
- EP-A2- 1 207 556
- WO-A1-2011/052781
- WO-A1-2011/114708
- WO-A1-2011/114708
- JP-A- 2000 228 884
- JP-A- 2000 228 884
- JP-A- 2002 176 191
- JP-A- H07 320 799
- JP-A- H1 039 056
- US-A- 4 152 597
- US-A- 4 728 878
- US-A1- 2010 069 667
- US-A1- 2012 092 857
- SIMON DALGLEISH ET AL: "Factors Affecting the Stability and Performance of Ionic Liquid-Based Planar Transient Photodetectors", LANGMUIR, vol. 31, no. 18, 30 April 2015 (2015-04-30), US, pages 5235 - 5243, XP055594446, ISSN: 0743-7463, DOI: 10.1021/la504972q
- KANAME KANAI ET AL.: "Electronic Structure of Organic Biradical Molecular Films", JOURNAL OF THE VACUUM SOCIETY OF JAPAN, vol. 56, no. l, 20 February 2013 (2013-02-20), pages 32 - 38, XP 055383542
- LAIGUI HU ET AL.: "Effect of photoinduced charge displacement on organic optoelectronic conversion", PHYSICAL REVIEW B, vol. 84, 21 November 2011 (2011-11-21), pages 205329 - 1 - 205329-5, XP 055383544
- YUKIKO NODA ET AL.: "16p-R-3 Yuki Tasomaku o Riyo shita Kokoritsu Kosoku Kodenryu Henkan = [High Efficiency Ultrafast Photoelectric Conversion in Organic Multilayer Photocells]", 71ST JAPAN SOCIETY OF APPLIED PHYSICS AUTUMN MEETING, 30 August 2010 (2010-08-30), XP009511105
- MASATO ODAKA ET AL.: "3D3-10 Substituent novel organic photocells operated by electric double layers in ionic liquids", 94TH ANNUAL MEETING OF THE CHEMICAL SOCIETY OF JAPAN IN SPRING 2014 NEN KOEN YOKOSHU II, vol. 94, 12 March 2014 (2014-03-12), pages 266, XP 009511099

## Description

### TECHNICAL FIELD

The present invention relates to a photoelectric conversion apparatus converting light energy into electric energy and then outputting the electric energy.

### BACKGROUND ART

As some of the photovoltaic cells utilizing an organic substance to convert light energy into electric energy, the following have been known: organic thin-film photovoltaic cells in which a charge separation occurs starting at the pn-junction in the same manner as the inorganic system photovoltaic cells; and dye sensitized photovoltaic cells in which a charge separation occurs starting at the adsorbed dye on the surface of titanium oxide.

It is inevitable to say that the organic thin-film photovoltaic cells and dye sensitized photovoltaic cells have an essentially disadvantageous structure for organic substances whose mobility is low because a direct electric current always keeps flowing within the devices. Moreover, the energy conversion surely leads to outputting a direct electric current, but does not result in outputting any alternating electric current at all.

For example, Patent Literature No. 1 discloses an example of the conventional technologies aiming at providing an organic photoelectric conversion element that can be fabricated inexpensively; in which the occurrence of dark current is suppressed as much as possible; and which generates, upon being subjected to a light, a transient current that is large and exhibits high-speed responsiveness. The organic photoelectric conversion element comprises: first and second electrodes whose work functions are made different from one another; a charge separation layer separating a charge when it is subjected to a light; and an insulative polarizer layer insulating the electrodes and charge separation layer from each another to polarize the electrodes and charge separation layer. Combining the charge separation layer with the insulative polarizer layer makes it possible to take out a large transient current.

### Related Technical Literature

### Patent Literature

Patent Literature No. 1: International Publication No. WO 2011/114708 .

Prior art can be found e.g. in document US 4,152,597 A disclosing an apparatus including effectively intrinsic semiconductor for converting radiant energy into electric energy, in document WO 2011/114708 A1 disclosing an organic photoelectric conversion element and imaging element, in document EP 1 596 460 A1 disclosing a light-detectable solid thin-film secondary battery, in document EP 1 207 556 A2 disclosing a light-receiving device and image sensor, in non-patent literature SIMON DALGLEISH et al.: "Factors Affecting the Stability and Performance of Ionic Liquid-Based Planar Transient Photodetectors" LANGMUIR, vol. 31, no. 18, 30 April 2015, pages 5235-5243, in document US 2010/0069667 A1 disclosing a plastic crystal, in document WO 2011/052781 A1 disclosing a photoelectric conversion element and photoelectric conversion device, in document JP 2000228884 A disclosing a solar generator apparatus and in document JP H10 39056 A disclosing an electronic apparatus and method for controlling the same with solar cells.

### SUMMARY OF THE INVENTION

### Assignment to be Solved by the Invention

However, the organic photoelectric conversion element disclosed in Patent Literature No. 1 outputs an alternating current only when it is subjected to an incoming intermittent light, such as an incoming chopped light. That is, letting a light simply fall on the organic photoelectric conversion element does not enable it to output an alternating current. Hence, when the organic photoelectric conversion element is required to output an alternating current, it has been suffering from such a problematic issue that it is necessary to utilize an external power source in order to activate a light chopper, or the like, to modulate a light.

The present invention has been made in view of the issues as described above. It is therefore an object of the present invention to provide a photoelectric conversion apparatus which self-oscillates to be capable of sustainably converting light energy into alternating electric energy.

### Means for Solving the Assignment

A first subject matter according to the present invention, which is made in order to solve the aforementioned problems, is a photoelectric conversion apparatus according to claim 1.

The first subject matter constructed as described above comprises the charge separator that separates the charges of carriers (i.e., positive holes and electrodes), and the insulative polarizer that accumulates the carriers to be charged in the incident state. Accordingly, a current flows from one of the electrodes (e.g., the first electrode) toward the other one of the electrodes (e.g., the second electrode). In the non-incident, the current flows from the other one of the electrodes toward the one of the electrode because the carries, which the insulative polarizer has accumulated, are discharged. That is, the current flows in the opposite directions in the incident state, and in the non-incident state. The incidence switcher switches between the incident state and the non-incidence state alternately. The combination of the charge separator, insulative polarizer and incidence switcher makes the photoelectric conversion apparatus self-oscillates, so that an alternating current or alternating voltage is output sustainably from the output terminals (i.e., the first electrode and second electrode). Moreover, the incidence switcher is able to make electric energy, which is output from the output terminals, alternate because it switches between the incident state and the non-incident state alternately based on the electromotive force that arises between the first electrode and the second electrode.

A predertermined time lag is provided between a change in the electromotive force and the switching between the incident state and the non-incident state by the incidence switcher. The thus constructed subject matter switches the incident state to the non-incident state after the electromotive force becomes so large in the incident state that the insulative polarizer has fully accumulated the carriers, or switches the non-incident state to the incident state after the insulative polarizer has fully discharged the carriers that it has accumulated in the non-incident state. A time lag is needed in the switching from the incident state to the non-incident state in order to charge the insulative polarizer, and another time lag is also needed in the switching from the non-incident state to the incident state in order to discharge the insulative polarizer. When the predetermined time lag is too short, the photoelectric conversion apparatus does not self-oscillate; and, even when the predetermined time lag is too long, the photoelectric conversion apparatus does not self-oscillate, either. As a result, the predetermined time lag is set up satisfactorily at appropriate numerical values depending on conditions related to the light, charge separator, insulative polarizer, incidence switcher, and so on. The predetermined time lag, which is set up appropriately, the alternating current or alternating voltage, which is output from the output terminals, to reliably self-oscillate, and makes the alternating current or alternating voltage sustainable.

A second subject matter according to the present invention is defined by claim 2. It features that the charge separator includes one or more members selected from the group consisting of organic compounds, inorganic compounds and metallic complexes, which are configured to separate a charge when they are subjected to the light. The thus constructed second subject matter allows the charge separator to be constituted of a material that is capable of reliably carrying out an electric power generation.

A third subject matter according to the present invention is defined by claim 3. It features that the charge separator includes one or more members selected from the group consisting of a donor and an acceptor, which have a charge-transfer absorption band. The thus constructed third subject matter permits the charge separator to be constituted of a material that is in compliance with a wavelength range of the light falling on the charge separator.

A fourth subject matter according to the present invention is defined by claim 4. It features that the charge separator includes a compound having a perovskite crystalline structure. The thus constructed fourth subject matter allows the present photoelectric conversion apparatus to carry out an electric power generation at low cost and highly efficiently, and permits to enhance the alternating current or alternating voltage.

A fifth subject matter according to the present invention is defined by claim 5. It features that the insulative polarizer includes an ionic liquid whose major components are a positive ion and a negative ion. The thus constructed fifth subject matter forms an electric double layer, which facilitates a charge separation and makes a large power-generating capacity obtainable, at an interface between the insulative polarizer and the charge separator.

A sixth subject matter according to the present invention is defined by claim 6. It features that the ionic liquid exhibits a plastic crystalline phase. The thus constructed sixth subject matter allows ensuring ions included in the ionic liquid to move freely, and permits preventing the ionic liquid from leaking to the outside from out of the present photoelectric conversion apparatus.

Note herein that the "current" flowing in a conductive wire connecting between the first electrode and the second electrode is mainly a transient current. The "charge separator" is arbitrarily or discretionarily formed of a material which is subjected to a light to be able to separate a charge, and involves compounds with a perovskite crystalline structure. The "insulative polarizer" is arbitrarily or discretionarily formed of a substance whose dielectric property is superior to the electric conductive property, and involves ionic liquids including a positive ion and negative ion as the major components. The "ionic liquid" comprises satisfactorily either a liquid or a gel in so far as the liquid or gel includes a positive ion and negative ion as the major components. Both of the paired electrodes, namely, both of the first and second electrodes, are used so as to change the polarities one another like electrodes in an alternating-current source. The term, "contact," involves joining, and implies forms in which polarization is conveyed from one member to another member via the contact face between them. The term, "transmission," involves reflections.

### BRIEF DESCRIPTION OF THE DRAWINGS

Fig. 1 is a schematic diagram illustrating a photoelectric conversion apparatus according to the present invention;
Fig. 2 is a schematic diagram illustrating an example of an incidence switcher not forming part of the present invention;
Fig. 3 is a cross-sectional view schematically illustrating how an example of a photoelectric conversion element according to the present invention is constructed;
Fig. 4 is a timing chart illustrating how output currents change with time according to an example not forming part of the present invention;
Fig. 5 is a timing chart illustrating how output voltages change with time according to an example not forming part of the present invention;
Fig. 6 is a graphic diagram illustrating an exemplary relationship between the output currents and the output voltages;
Fig. 7 is a side view schematically illustrating a photoelectric conversion apparatus according to the present invention;
Fig. 8 is a plan view schematically illustrating a photoelectric conversion apparatus according to the present invention;
Fig. 9 is a schematic diagram illustrating an an incidence switcher according to another embodiment of the present invention;
   and
Fig. 10 is a timing chart illustrating how an output changes with time.

### MODE FOR CARRYING OUT THE INVENTION

Forms for executing or implementing the present invention will be hereinafter described based on the drawings. Note that, unless otherwise specified explicitly, the word, "connect," means to electrically connect members with each other when they are used. The respective drawings illustrate elements needed for describing the present invention, but do not necessarily illustrate all of the actual elements. When referring to directions, such as up, down, right and left, they are based on notes or designations implied or shown in the drawings.

### (Example not forming part of the present invention)

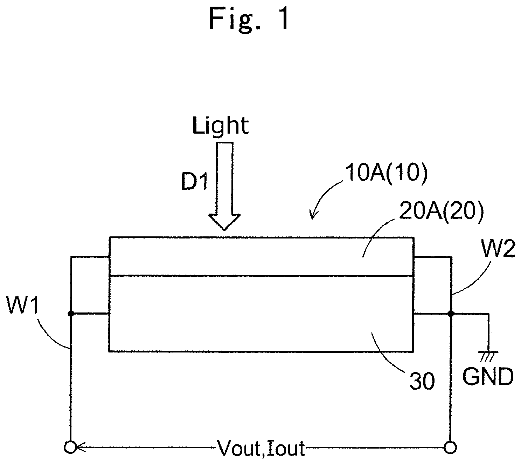

An example of a photoelectric conversion apparatus not forming part of the invention will be hereinafter described with reference to Figs. 1 through 6. A photoelectric conversion apparatus 10A illustrated in Fig. 1 is one of the examples or variations of a photoelectric conversion apparatus 10. The photoelectric conversion apparatus 10A comprises an incidence switcher 20A, and a photoelectric conversion element 30.

The incidence switcher 20A, and the photoelectric conversion element 30 are connected with one another by conductive wires "W1" and "W2." One of the conductive wires "W1" and "W2" is connected satisfactorily with a ground "GND " The ground "GND" is a common potential, and is not necessarily limited to zero volts. When the ground "GND" is grounded, it is zero volts . As described later, since an output voltage "Vout," and an output current "Iout" are alternating electrically, the conductive wire "W2" is connected satisfactorily with the ground "GND" as shown in Fig. 1, or the conductive wire "W1" can instead be connected properly with the ground "GND," although the alternative is not illustrated in the drawing.

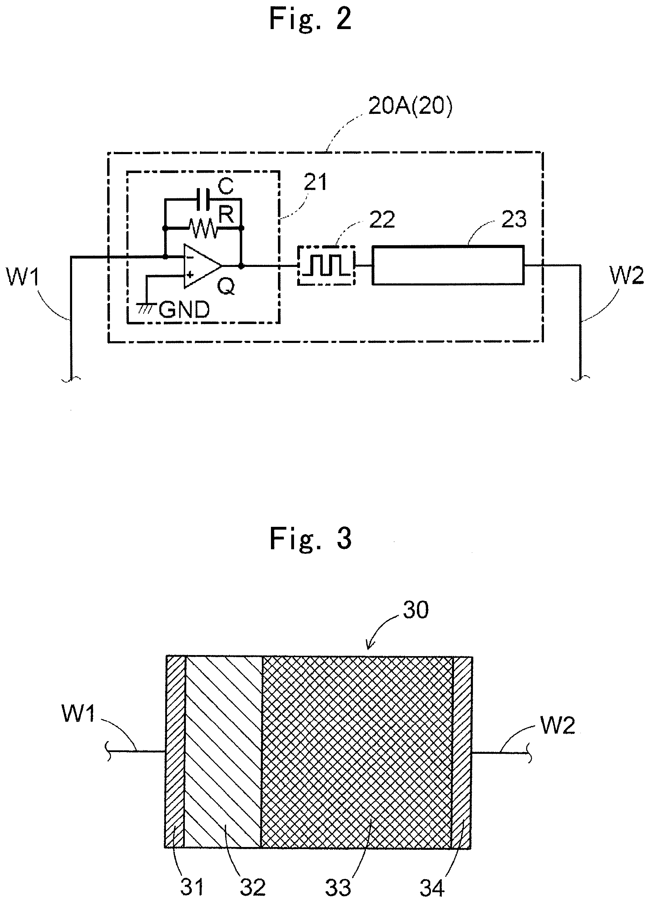

The incidence switcher 20A is one of the examples or variations of an incidence switcher 20 not forming part of the present invention. The incidence switcher 20A, which is shown with the chain line in Fig. 2, includes a liquid-crystal shutter 23. The incidence switcher 20A satisfactorily further includes at least an amplifier 21 and signal generator 22, which are enclosed with the chain double-dashed line in the drawing, in addition to the liquid-crystal shutter 23, if needed.

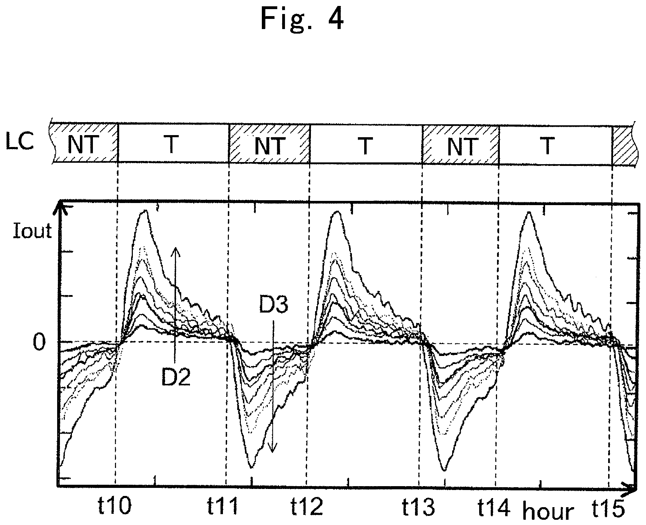

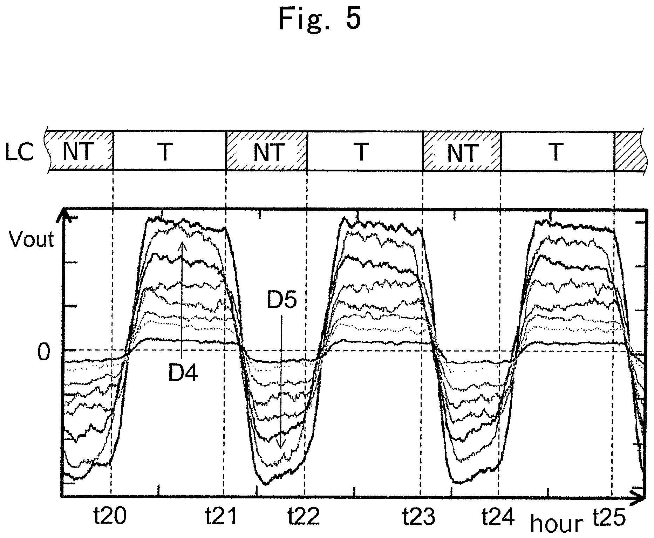

The amplifier 21 amplifies electric energy, which is output from the photoelectric conversion element 30, and then outputs the amplified electric energy. The incidence switcher 20A preferably includes the amplifier 21 when the electric energy, which is output from the photoelectric conversion element 30, cannot directly activate the liquid-crystal shutter 23. The electric energy is an electric power, and involves the output current "Iout" shown in Fig. 4 and the output voltage "Vout" shown in Fig. 5. Note that, in this example, the output voltage "Vout" is applied to the electric energy.

The amplifier 21 can be constructed arbitrarily or discretionarily as far as it is capable of amplifying electric energy and then outputting the amplified electric energy. An example of the construction illustrated in Fig. 2 is an inversion amplifier comprising a capacitor "C," a resistor "R," and an operational amplifier "Q." In order to compensate the phase by preventing the oscillation, the capacitor "C" and resistor "R" are connected in parallel to make a lowpass filter. The amplifier 21 carries out a negative-return feedback because the parallely-connected capacitor "C" and resistor "R" are connected at one of the opposite ends with the negative input terminal (also referred to as the "inverting input terminal") of the operation amplifier "Q," and at the other one of the opposite ends with the output terminal. The operation amplifier "Q" is connected at the positive input terminal (also referred to as the "non-inverting input terminal") with the ground "GND, " and at the negative input terminal with the conductive wire "W1." In this example, the capacitor "C" is made to exhibit an electrostatic capacitance of 100 pF, and the resistor "R" is made to exhibit a resistance value of 100 MΩ.

The signal generator 22 generates switching signals for switching the liquid-crystal shutter 23 between the passing mode and the blocking mode based on the amplified output voltage "Vout," and then outputs them. When electric energy output from the photoelectric conversion element 30 is assumed to be an electric-power signal, the incidence switcher 20A preferably includes the signal generator 22 in a case where it is necessary to generate the switching signals while providing a time lag between the switching signals and the electric-power signal in order to continuously self-oscillate the photoelectric conversion apparatus 10A. A form of the switching signals can be set up arbitrarily or discretionarily, and involves pulse signals, data signals, and the like, for instance. A frequency at which the liquid-crystal shutter 23 is switched between the passing mode and the blocking mode can be set up arbitrarily or discretionarily, and is satisfactorily tuned to the frequency of commercial power source (e.g., 50 Hz or 60 Hz, and so forth). The liquid-crystal shutter 23 makes a light, which falls on from the outside toward the photoelectric conversion element 30, transmissive and non-transmissive.

The liquid-crystal shutter 23 can be constructed arbitrarily or discretionarily as far as it is capable of making a light, which comes from the outside, transmissive and non-transmissive. Although the following are abbreviated in the drawing, the liquid-crystal shutter 23 according to this example comprises a liquid-crystal panel, which does not include any light source but includes a polarizing filter, and a driver circuit for driving the liquid-crystal panel. When a light transmits through the liquid-crystal shutter 23, the light is put in the incident state where it falls on the photoelectric conversion element 30. On the contrary, when a light does not transmits through the liquid-crystal shutter 23, the light is put in the non-incident state where it does not fall on the photoelectric conversion element 30.

An arbitrary or discretionary light source is employed to emit the light. The light source can satisfactorily be a natural light, such as the solar light, or may properly be an artificial light emitted by electric light or the like. It does not matter whether the light is a direct light or an indirect light, or whether the light's light intensity, brightness, and the like, change with time. However, an applicable light involves stationary lights emitted continuously. The light falls on the photoelectric conversion element 30 satisfactorily from any directions as far as it is capable of impinging on and then exciting the photoelectric conversion element 30. For example, the incident direction shown with the arrow "D1" in Fig. 1 is nothing but one of the examples. The light has an arbitrary or discretional wavelength as far as it makes the photoelectric conversion element 30 generate an electromotive force. For instance, the light can satisfactorily be made up a plurality of wavelengths, like the solar light; or may properly be made up of a single wavelength, like laser lights and LED lights.

As illustrated in Fig. 3, the photoelectric conversion element 30 comprises a first electrode 31, a charge separation layer 32, an insulative polarizer layer 33, and a second electrode 34. The first electrode 31 and second electrode 34 correspond to the claimed "a pair of electrodes, " and are satisfactorily formed of an arbitrary or discretional material exhibiting electric conductive property. It does not matter whether the first electrode 31 and second electrode 34 exhibit different work functions from one another, or whether they are transparent or not. As set forth in Dictionary of Physics and Chemistry (5th Edition, Published by IWANAMI SHOTEN in 1998), the term, "work function, " means a minimum energy required for taking out an electron from the surface of substance (such as the crystal of metal or semiconductor) to the outside. Making the work function of the first electrode 31 different from that of the second electrode 34 augments or builds up a charge separation within the charge separation layer 32. The insulative polarizer layer 33 as well helps the charge separate. That is, the insulative polarizer layer 33 conveys polarization, which has occurred within the charge separation layer 32, to the first electrode 31 and second electrode 34. Accordingly, a transitional potential difference arises between the first electrode 31 and the second electrode 34. Consequently, the response characteristics of a photoelectric conversion element, for instance, a time required for the photoelectric conversion element 30 to output a transient current after being subjected to a light, are enhanced more than those of its predecessors. The result is a higher light/current conversion efficiency, and a shorter light/current conversion time.

When exciting the charge separation layer 32 by way of one of the electrodes, the electrode is required to exhibit transparency. The following are pertinent materials for transparent electrically conducting member: tin oxide with antimony or fluorine doped, such as ATO or FTO; and electrically conducting metallic oxides, such as tin oxide, zinc oxide, indium oxide, indium tin oxide (or ITO) and indium zinc oxide (or IZO). The first electrode 31 and second electrode 34 can even be a thin film made of metal, such as gold, silver, chromium or nickel. The first electrode 31 and second electrode 34 may also be made of a thin film including a mixture of an electric conducting metallic oxide and metal, or a laminated member including thin films made of an electric conducting metallic oxide and metal. The first electrode 31 and second electrode 34 can even be made of an inorganic electrically conducting substance, such as copper iodide or copper sulfide. The first electrode 31 and second electrode 35 may also be made of an organic electrically conducting substance, such as carbon nanotube, polypyrrole, polyaniline, polythiophene, polypyrrole, or polyethylenedioxythiophene (or PEDOT). The first electrode 31 and second electrode 34 can even be a laminated substance which is formed by laminating indium tin oxide (or ITO) and at least one member selected from the group consisting of the metals, the inorganic electrically conducting substances and the organic electrically conducting substances. From the viewpoints, such as high electrically conducting property and transparency, the first electrode 31 and second electrode 34 are desirably made of a transparent and electrically conducting metallic oxide.

The charge separation layer 32 corresponds to the claimed "charge separator." The charge separation layer 32 can be satisfactorily formed of an arbitrary or discretional material in any configuration as far as the material comprises a compound separating a charge when being subjected to a light. It does not matter whether or not the material is a semiconductor. Note herein that the term, "semiconductor, " involves all types of semiconductors, such as p-type and n-type semiconductors. That is, the charge separation layer 32 is properly made of a material, which separates a charge into positive holes or electrons and then moves the resulting positive holes or electrodes to the first electrode 31 or second electrode 34, upon being subjected to a light. Provided that the charge separation layer 32 is able to separate a charge when it is subjected to a light, it preferably further comprises one or more other materials selected from the group consisting of organic compounds, inorganic compounds and metallic complexes. The charge separation layer 32 has a thickness that is satisfactorily set up from the viewpoints, such as making a charge likely to be separated when being subjected to a light and reliably producing a desired electromotive force, because the charge separation layer 32 is likely to separate a charge as it becomes thinner but the resulting electromotive force becomes smaller adversely.

A preferable exemplary material for the charge separation layer 32 is a compound having a perovskite structure, for instance. To be concrete, the charge separation layer 32 preferably comprises a ternary compound expressed by a general formula ABX₃, such as barium titanate (BaTiO₃) and methylammonium lead iodide (CH₃NH₃PbI₃). Metallic ions, alkyl groups and amino groups are pertinent to the "A, " "B" and "X." A perovskite structure is established by combining an A ion with a B ion so as to make a sum of the atomic valences three on average. In the case of oxides in which oxygen makes the "X, " such combinations as A²⁺B⁴⁺O₃, A¹⁺B⁵⁺O₃ and A³⁺B³⁺O₃ are available, for instance.

The charge separation layer 32 is preferably made of a donor or acceptor having an absorption band falling in a range of a specific wavelength region that the incident light contains, a charge-transfer complex (e.g., an intermolecular compound of the donor and acceptor) having a charge-transfer absorption band falling in a range of the specific wavelength region, or a mixture of the donor and acceptor, and the like. That is, as far as the charge separation layer 32 causes a charge separation, it is satisfactorily formed using a donor and acceptor that excite the absorption band containing the charge-transfer band. Note herein that the term, "donor," implies an "electron-donating compound" corresponding to the compounds that are likely to donate electrons. Likewise, the term, "acceptor," implies an "electron-accepting compound" corresponding to the compounds that are likely to accept electrons.

When the specific wavelength region falls in a range of a visible light's wavelength region, the charge separation layer 32 is formed of a charge-transfer complex of a donor and acceptor having a charge-transfer absorption band falling in the visible light's wavelength region, or a mixture of the donor and acceptor. Likewise, when the specific wavelength region falls in a range of an ultraviolet light's wavelength region, the charge separation layer 32 is formed of a donor or acceptor having an absorption band falling in the ultraviolet light's wavelength region, or a mixture of the donor and acceptor.

Although a combination of the donor and acceptor is determined relatively by an energy level of a targeted compound making a subject of the combination, an arbitrary or discretional material is applied satisfactorily to the targeted compound. For example, a pertinent combination involves the following are: phthalocyanine (abbreviated sometimes as "M-PC") serving as the donor; and a fullerene compound serving as the acceptor. An applicable ligand "M" coordinated at the center of phthalocyanine involves the following: H₂, TiO, VO, Mn, Fe, Co, Zn, Sn, Pb, and Li. In addition to fullerene C₆₀, a pertinent fullerene compound involves the following: fullerene C₇₀, fullerene C₇₆, fullerene C₇₈, fullerene C₈₀, fullerene C₈₂, fullerene C₈₄, fullerene C₉₀, fullerene C₉₆, fullerene C₂₄₀, fullerene C₅₄₀, mixed fullerenes, and fullerene nanotubes.

The above-described fullerene compounds includes satisfactory fullerene derivatives to which substitution groups are added. Arbitrary or discretional groups are applicable to the substitution groups. For example, the following are pertinent substitution groups: a halogen atom, an alkyl group, an alkenyl group, an alkynyl group, an aryl group, a heterocyclic group, a cyano group, a hydroxyl group, a nitro group, a carboxyl group, an alkoxy group, an aryloxy group, a silyloxy group, a heterocycloxy group, an acyloxy group, a carbamoyloxy group, an alkoxy carbonyloxy group, an aryl oxycarbonyloxy group, an amino group, an ammonio group, an amino carbonylamino group, an alkoxy carbonyl amino group, an aryl oxycarbonylamino group, a sulfamoylamino group, an alkyl sulfonylamino group, an aryl sulfonylamino group, a mercapto group, an alkylthio group, an arylthio group, a heterocyclic thio group, a sulfamoyl group, a sulfo group, an alkyl sulfinyl group, an aryl sulfinyl group, an alkyl sulfonyl group, an aryl sulfonyl group, an acyl group, an aryl oxycarbonyl group, an alkoxy carbonyl group, a carbamoyl group, an aryl azo group, a heterocyclic azo group, an imide group, a phosphino group, a phosphinyl group, a phosphinyloxy group, a phosphinylamino group, a phosphono group, a silyl group, a hydrazino group, a ureido group, a borate group, a phosfato group, and a sulfato group.

Other than a mixture of the above-described donor and acceptor, the charge separation layer 32 is satisfactorily made of a single-component substance. A pertinent single-compound substance involves Chia Jill radicals (BDTDA), and N-ethylphenazyl crystals.

When the aforementioned specific wavelength region falls in a range of an infrared light's wavelength region (desirably, a near-infrared light's wavelength), the charge separation layer 32 is formed of a charge-transfer complex of a donor and acceptor having a charge-transfer absorption band falling in the infrared light's wavelength region (or the near-infrared light's wavelength region), or a mixture of the donor and acceptor. Arbitrary or discretional substances, which satisfy the aforementioned conditions, are applicable to the donor-and-acceptor combination. For example, a pertinent donor-and-acceptor combination is a combination of tetrathiafulvalene (or TTF) serving as the donor and chloranil (or CA) serving as the acceptor. Moreover, another pertinent donor-and-acceptor combination is a combination of a cyclic dithiazole compound (or NT) serving as the donor and tetracyanoquino-dimethane (or TCNQ) serving as the acceptor.

The insulative polarizer layer 33 corresponds to the claimed "insulative polarizer." The insulative polarizer layer 33 is satisfactorily formed of an arbitrary or discretionary material (e.g., an ionic liquid or solid insulator, and the like, for instance), which has both insulating and electrically-accumulating properties, in an arbitrary or discretionary configuration. That is, the insulative polarizer layer 33 facilitates a charge separation in the charge separation layer 32, and carries out the function of making the second electrode 34 likely to absorb the separated charge. The insulative polarizer layer 33 has a thickness that is properly set up from the viewpoints, such as exhibiting a much larger electric capacitance reliably and making the insulative polarizer layer 33 likely to polarize, because the insulative polarizer layer 33 exhibits a decreased electric capacity as it becomes thicker, and its polarization is reduced so that the resulting electromotive force becomes smaller. The insulative polarizer layer 33 has an electric capacitance that is satisfactorily set up so that an alternating current (i.e., the output current "Iout" described later) or alternating voltage (i.e., the output voltage "Vout" described later) attains their targeted values (e.g., the maximum value, the amplitude value, and the like).

The insulative polarizer layer 33 is possibly formed of an arbitrary or discretional material. For example, anionic liquid including a positive ion and negative ion as the major components is also applied satisfactorily to the insulative polarizer layer 33. In general, an ionic liquid exerts extremely low vapor pressures, and exhibits inflammability or noncombustibility. Since the ionic liquid is sometimes referred to as an "ordinary-temperature molten salt, " many ionic liquids have a melting point which is present at around room temperature. The ionic liquid according to First Embodiment is preferably a liquid in the service temperature range.

The positive ion is not at all limited especially. The following are given however as some of the examples applicable to the positive ion: a cation of nitrogen-containing compound; a quaternary phosphonium cation; or a sulfonium cation. For example, a pertinent cation of nitrogen-containing compound involves the following: a heterocyclic aromatic cation, such as an imidazolium cation or pyridinium cation; a heterocyclic aliphatic cation, such as a piperidinium cation, pyrrolidinium cation, pyrazolium cation, thiazolium cation or morpholinium cation; a quaternary ammonium cation; or a cation with a form to which an aromatic amine, aliphatic amine or alicyclic amine is added.

The negative ion is not at all limited especially. For example, a pertinent negative ion involves the following: a halide anion, such as Cl⁻, Br⁻ or I⁻; a boride anion, such as BF4⁻, B(CN)₄⁻ or B(C₂O₄)₂⁻; an amide anion or imide anion, such as (CN)₂N⁻, [N(SO₂F)₂], [N(SO₂CF₃)₂]⁻ or [N(SO₂C₂F₅)₂]⁻; a sulfate anion or sulfonate anion, such as RSO₃⁻, RSO₄⁻, RfSO₃⁻ or RfSO₄⁻; a phosphate anion, such as Rf₂P(O)O⁻, PF₆⁻ or Rf₃P₃⁻; an antimony anion, such as SbF₆⁻. Note that "R" expresses an aliphatic hydrocarbon group or aromatic hydrocarbon group, and "Rf" expresses a fluorine-containing halogenated hydrocarbon group. In addition to the above, other various negative ions, such as lactate, a nitrate ion or trifluoroacetate, are also applicable to the negative ion.

The ionic liquid also comprises satisfactorily a combination of a cation and anion, each of which is one member selected from the group consisting of the above-described cations and anions. Moreover, the ionic liquid even comprises properly a cation and anion, one of which or both of which are two or more members selected from the group consisting of the above-described cations, and which coexist mixedly therein.

In addition, the ionic liquid is also made preferably using a gel, or an ionic liquid exhibiting a plastic crystalline phase. The plastic crystal might sometimes be called a soft-viscous crystal as well. The plastic crystal is not only a substance showing the state of intermediate phase which has flexibility while taking a crystalline form, but also is a substance exhibiting relatively high ionic conductivity. The plastic crystal, which is heated to a high temperature, melts down in the same manner as ordinary crystals. Contrary to a crystal state in which ions are fixed substantially completely, a plastic crystal offers such an advantage that ions can move freely to a certain extent within the plastic crystalline phase. Accordingly, the ionic liquid showing a plastic crystalline phase maintains a soft-polymer-like configuration at room temperature while exhibiting the inflammable and noncombustible properties. Consequently, the ionic liquid showing a plastic crystalline phase not only little leaks out, but also allows producing performance equivalent to that of simple ionic liquid.

Instead of the above-described ionic liquid, the insulative polarizer layer 33 is made satisfactorily using a solid insulator. A pertinent solid insulators involves the following fluorine-based plastics (or fluorine resins), for instance: polyvinylidene difluoride (or PVDF); polyvinyl fluoride (or PVF); polytetrafluoroethyelene (or PTFE); tetrafluoroethylene-ethylene copolymers (or ETFE); tetrafluoroethyelene-hexafluoropropylene copolymers (or FEP); tetrafluoroethyelene-perfluoroalkyl-vinylether copolymers (or PFA); polychloro-trifluoroethylene (or PCTFE); and chlorotrifluoroethylene-ethyelene copolymers (or ECTFE). Note that, not limited to the substances, the insulative polarizer layer 33, can also be satisfactorily formed of a space in which a charge moves with extremely great difficulty, namely, a vacuumed or semi-vacuumed space.

The photoelectric conversion element 30 is manufactured arbitrarily or discretionarily. For example, the photoelectric conversion element 30, which has a structure illustrated in Fig. 3, is satisfactorily fabricated in turn from the left side, namely, from the first electrode 31, to the right side; or is satisfactorily fabricated in turn from the right side, namely, from the second electrode 34, to the left side. The charge separation layer 32 and insulative polarizer layer 33 are formedproperly as an integrally-molded organic layer as a whole. The charge separation layer 32 and insulative polarizer layer 33 are satisfactorily molded integrally together with the first electrode 31 and second electrode 34 that are made of an organic material. The charge separation layer 32, and the insulative polarizer layer 33 are properly brought into contact with one another after molding them separately.

An electromotive force, which arises between the first electrode 31 and charge separation layer 32 of the photoelectric conversion element 30, desirably changes steeply, namely, rises up and rises down quickly. The incidence switcher 20 also desirably switches between the incident state and the non-incident state quickly. The faster the steepness or quickness is in the time scale, the more preferable it is, namely, the shorter a time required for the change is, the more preferable it is. A preferable condition, under which the photoelectric conversion apparatus according to the example self-oscillates, is faster than a predetermined time lag, namely, the present photoelectric conversion apparatus preferably self-oscillates more shortly or briefly in terms of time.

The predetermined time lag is set up satisfactorily at a suitable numerical value in compliance with types of the light and the respective constructions of the charge separation layer 32, insulative polarizer layer 33, incidence switcher 20, and so on. In order that the photoelectric conversion apparatus according to the example self-oscillates, the predetermined time lag is set up properly at a time that is longer than the present photoelectric conversion apparatus's up-rising and down-rising times. That is, the predetermined time lag
satisfies a relationship, (Switching Time)≦ (Time Lag). When a change in the electromotive force has an inherent time lag, it is not necessarily required to use an external circuit for providing the predetermined time lag. That is, a pertinent predetermined time lag involves a time lag upon switching the incidence switcher 20 to the non-incidence state after the charge separation layer 32 carries out a charge separation to enlarge the electromotive force as it is subjected to the incident light so that the insulative polarizer layer 33 has accumulated the carries. Moreover, another pertinent predetermined time lag involves a time lag upon switching the incidence switcher 20 to the incident state after the insulative polarizer layer 33, on which the incident light has come not to fall, has discharged the accumulated carriers. Setting up the predetermined time lag adequately allows the first electrode 31 and second electrode 34, the output terminals, to output an alternating current or alternating voltage that self-oscillates, and permits them to sustainably output it.

Next, an example of how the photoelectric conversion apparatus 10 operates will be hereinafter described while referring to Figs. 4 through 6. The photoelectric conversion element 30, which produced the characteristic curves shown in Figs. 4 and 5, was constructed in the following manner. The first electrode 11 was made using indium oxide (e.g., ITO/PEDOT: PSS). The charge separation layer 32 was made using methylammonium lead iodide (e.g., CH₃NH₃PBI₃) having a perovskite crystalline structure. The insulative polarizer layer 33 was made using one of the ionic liquids, N-diethyl-N-methyl-N-(2-methoxyethyl) ammonium-tetrafluoroborate (or DEME-BF₃). The second electrode 34 was made using aluminum (Al). An incident light fell on the photoelectric conversion apparatus 10 from the ITO side, making the ITO a cathode. Note the thus constructed present photoelectric conversion apparatus 10 is one of examples not forming part of the present invention, and that combinations, which are constructed by arbitrarily or discretionarily combining the above-described materials used for the respective constituents, produced the same results as those described later.

Measuring a current with an ammeter connecting between the conducting wire "W1" and the conducting wire "W2" resulted in the output current "Iout" shown in Fig. 4. The diagrammatic designation, "LC" shown in the upper half, illustrates how the liquid-crystal shutter 23 operated. The diagrammatic designation, "T," implies that the light transmitted through the liquid-crystal shutter 23 to be in the incidence state where the light made an incident light falling on the photoelectric conversion element 30 and then transmitting through it. The diagrammatic designation, "NT," implies being non-transmissive, namely, the light did not transmit through the liquid-crystal shutter 23 to be in the non-incidence state where the light did not make any incident light falling on the photoelectric conversion element 30. The non-transmission, "NT," is marked with the hatched lines in order to readily distinguish "NT" from "T." Specifically, the light transmitted through the liquid-crystal shutter 23 from a time "t10" to a time "t11," from a time "t12" to a time "t13," and from a time "t14" to a time "t15, " respectively. The light did not transmit through the liquid-crystal shutter 23 from the time "t11" to the time "t12," and from the time "t13" to the time "t14," respectively.

The output current "Iout" changed in the positive direction when the light fell on the photoelectric conversion element 30, whereas the output current "Iout" changed in the negative direction when the light did not fall on the photoelectric conversion element 30. That is, the charge separation layer 32, on which the light fell, excited energetically to separate a charge into the positive holes and electrons. In the process, the charge separation layer 32 polarized. The polarized charge separator 32 polarized the insulative polarizer layer 33. The polarized insulative polarizer layer 33 conveyed the resulting polarization to the conductive wires "W1" and "W2" so that the output current "Iout" flowed in the positive direction. The charge separation layer 32, on which the light did not fall, canceled the polarization. Consequently, the output current "Iout" flowed in the conductive wires "W1" and "W2" in a direction that was opposite to the direction when the light fell on the charge separation layer 32, namely, in the negative direction. Therefore, the output current "Iout" made an alternating current. Note that, depending on how the charge separation layer 32 was constructed, the output current "Iout" exhibited amplitudes that changed as shown with the arrows "D2" and "D3."

Measuring a voltage with a voltmeter connecting between the conducting wire "W1" and the conducting wire "W2" resulted in the output voltage "Vout" shown in Fig. 5. The diagrammatic designation, "LC" shown in the upper half, illustrates exactly the same as that is illustrated in Fig. 4. Hence, the light transmitted through the liquid-crystal shutter 23 from a time "t20" to a time "t21," from a time "t22" to a time "t23," and from a time "t24" to a time "t25," respectively. The light did not transmit through the liquid-crystal shutter 23 from the time "t21" to the time "t22," and from the time "t23" to the time "t24," respectively. The output voltage "Vout" made an alternating voltage, because it changed in accordance with the charge separation and polarization in the same manner as the output current "Iout" shown in Fig. 4. Note that, depending on how the charge separation layer 32 was constructed, the output voltage "Vout" exhibited amplitudes that changed as shown with the arrows "D4" and "D5."

Note that Figs. 4 and 5 show examples that made a transmissive period for transmitting the light through the liquid-crystal shutter 23 and a non-transmissive period for not transmitting the light through the liquid crystal shutter 23 different from one another. Naturally, it is also possible to switch the liquid-crystal shutter 23 between the passing mode and the blocking mode so as to make the transmissive period and non-transmissive identical with one another.

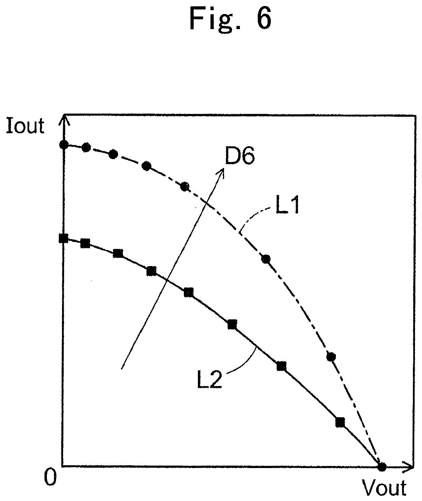

Fig. 6, whose vertical axis is labeled the output current "Iout" and horizontal axis is labeled the output voltage "Vout," shows characteristics whose alternating frequency was changed. The characteristics, whose alternating frequency was 400 Hz, changed as shown with the characteristic curve "L1"; whereas the characteristics, whose alternating frequency was 50 Hz, changed as shown with the characteristic curve "L2." As the arrow "D6" illustrates diagrammatically, the output current "Iout" enlarged as the alternating frequency increased. In other words, increasing the alternating frequency satisfactorily enlarges the output current "Iout" greatly as much as needed.

The liquid-crystal shutter 23 illustrated in Fig. 2 switches between the passing mode and the blocking mode based on the signals that the signal generator 22 transmits. Accordingly, the liquid-crystal shutter 23 makes the photoelectric conversion apparatus 10 according to the example output the output current "Iout" and output voltage "Vout" for every single cycle. Consequently, in order to obtain the characteristic curve "L1" whose frequency is 400 Hz, the signal generator 22 satisfactorily outputs the signals that make the liquid-crystal shutter 23 alternately switch between the passing mode and the blocking mode repetitively for 400 times in one second. Similarly, in order to obtain the characteristic curve "L2" whose frequency is 50 Hz, the signal generator 22 properly outputs the signals that make the liquid-crystal shutter 23 alternately switch between the passing mode and the blocking mode repetitively for 50 times in one second. That is, the signal generator 22 generating the signals, which is set up or controlled adequately, allows the present photoelectric conversion apparatus 10 to output the output current "Iout" and output voltage "Vout" with a targeted frequency.

### (Embodiment according to the present invention)

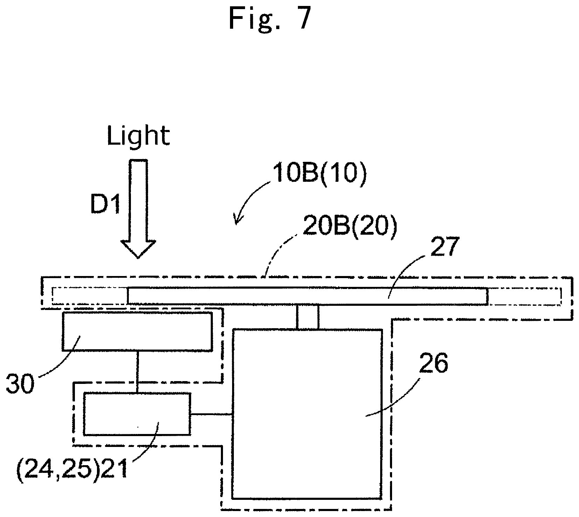

An embodiment of a photoelectric conversion apparatus according to the present invention will be hereinafter described with reference to Figs. 7 through 9. Note that, in order to concisely illustrate and describe the Embodiment, descriptions on the same constituents as those employed in the example will be omitted by designating them with identical reference numerals or symbols unless specified otherwise explicitly. Hence, descriptions on the Embodiment will be hereinafter provided mainly regarding only the features that are distinct from those of the example.

The photoelectric conversion apparatus 10B illustrated in Figs. 7 through 9 is one of the examples of the photoelectric conversion apparatus 10. The photoelectric conversion apparatus 10B comprises an incidence switcher 20B, and the photoelectric conversion element 30. The photoelectric conversion apparatus 10B differs from the photoelectric conversion apparatus 10A in that the incidence switcher 20B is used instead of the incidence switcher 20A.

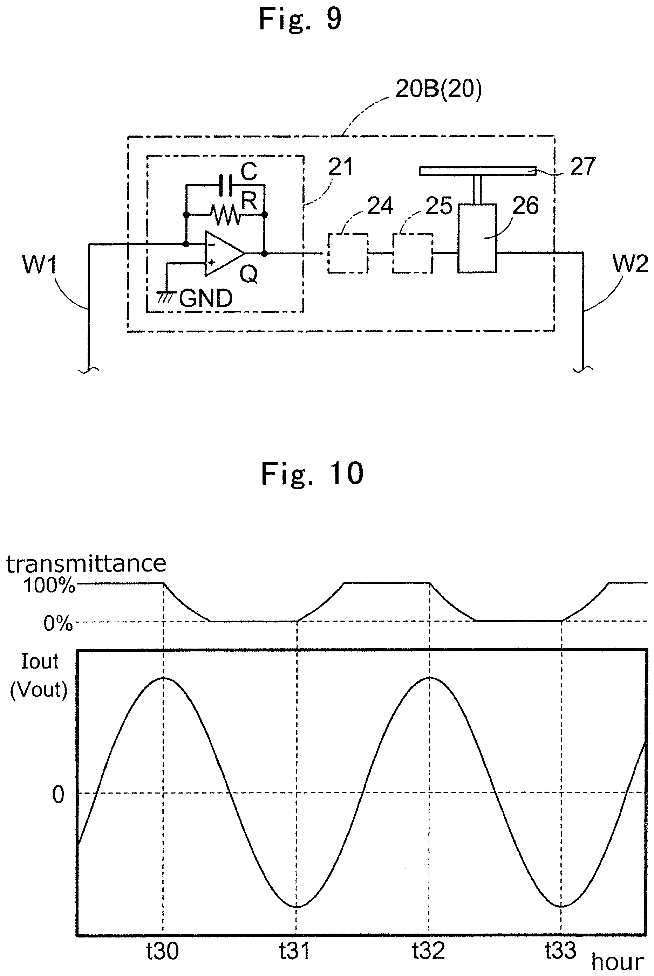

The incidence switcher 20B, an equivalent of the claimed "movement mechanism," comprises an amplifier 21, a motor 26, and an opaque member 27. In addition to these constituent elements, the incidence switcher 20B satisfactorily further comprises a rectifier 24 and inverter 25 illustrated in Fig. 9.

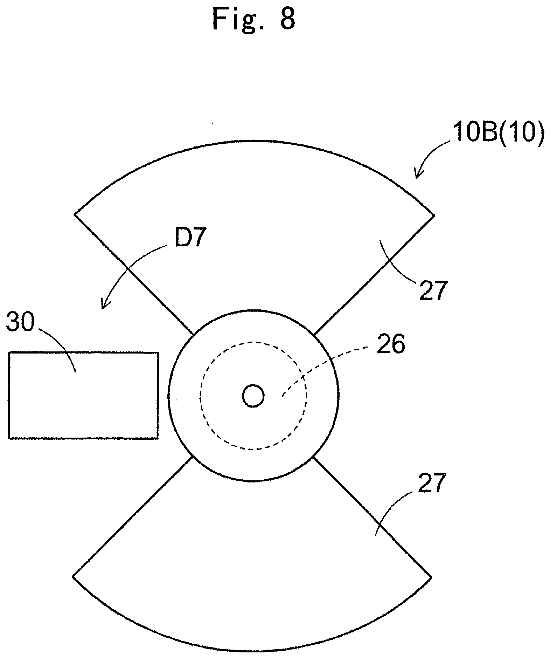

The motor 26 rotates the opaque member 27 in accordance with signals output from the amplifier 26. The opaque member 27 is fixed onto the motor 26 at the rotary shaft so that it passes through an interspace between the light source and the photoelectric conversion element 30. As far as the opaque member 27 is capable of shutting off the light, it does not matter how the opaque member 27 is formed in terms of the material, configuration, quantity, and the like. The opaque member 27 has any arbitrary or discretional configurations enabling the incidence switcher 20B to alternately switch between the incidence state, where the light transmits through it, and the non-incidence state, where the light does not transmit through it, as the opaque member 27 rotates. The motor 26 can satisfactorily rotate in the counterclockwise direction designated with the arrow "D7" in Fig. 8, or may properly rotate in the clockwise direction not-shown in the drawing. Fig. 8 illustrates an example composed of two opaque members 27 that are molded as a fan-shaped configuration having a 90-degree central angle. Although not illustrated in the drawing, the opaque members 27 are molded satisfactorily as a configuration other than the fan-shaped configuration. Moreover, the fan-shaped configuration properly has the central angle, which is set up arbitrarily or discretionarily, as far as it is capable of ensuring the non-incident state where the light does not fall on the charge separation layer 32.

In order to stably rotate the motor 26, the incidence switcher 20B further comprises the rectifier 24 preferably, and furthermore comprises the inverter 25 more preferably. The rectifier 24 satisfactorily includes the following: an element capable of outputting a constant voltage (such as a Zener diode, for instance) or a constant-voltage circuit; or another element capable of outputting a constant current (such as a constant-current diode, for instance) or a constant-current circuit. The motor 26 made of a direct-current motor is driven by a direct current that is obtained by converting an alternating current, which the photoelectric conversion element 30 outputs, into the driving direct current with the rectifier 24 rectifying the alternating current. The motor 26 made of an alternating-current motor is driven by an alternating current that is obtained by converting an alternating current, which the photoelectric conversion element 30 outputs, into a direct current with the rectifier 24 rectifying the alternating current and then further converting the resultant direct current into the driving alternating current with the inverter 25 inverting the direct current into the alternating current.

The photoelectric conversion apparatus 10B according to the Embodiment outputs a two-cycle output current "Iout" and output voltage "Vout, " because the opaque members 27 illustrated in Fig. 8 switches between the incidence state and the non-incidence state twice each time the motor 26 rotates once. Hence, the motor 26 is rotated at a revolving speed of 200 rpm in order to make the characteristic curve "L1" shown in Fig. 6 exhibit a frequency of 400 Hz. Similarly, the motor 26 is rotated at a revolving speed of 25 rpm in order to make the characteristic curve "L2" exhibit a frequency of 50 Hz. That is, setting up or controlling the revolving speed of the motor 26 adequately allows outputting the output current "Iout" and output voltage "Vout" with a targeted frequency.

### (Other Embodiments)

Although modes for executing or implementing the present invention have been described so far in accordance with the example and the Embodiment, the present invention is not at all limited to the embodiment. In other words, the present invention is executed or implemented variously in other modes within a range not departing from the present invention as defined by the appended claims. For example, the present invention is materialized satisfactorily by each of modes described below.

Above-described Embodiment comprises the incidence switcher 20B including the opaque member 27, which is formed as a fan-shaped configuration whose central angle is 90 degrees as shown in Fig. 8, in a quantity of two. Instead of the mode, the incidence switcher 20B satisfactorily includes the opaque member 27, which is formed as a predetermined configuration whose central angle is other than 90 degrees, in a quantity of multiple pieces. The predetermined configuration is satisfactorily the fan-shaped configuration, or is properly the other geometric configurations such as triangles and quadrangles. For example, the following are pertinent modes in terms of the central angle and quantity: the opaque member 27, which is formed to have a central angle of 60 degrees, in a quantity of three; and the opaque member 27, which is formed to have a central angle of 45 degrees, in a quantity of four. As the quantity increases, the motor 26 is rotated satisfactorily at a decreased revolving speed, which allows suppressing the consumption of energy required for driving the motor 26. Other movement mechanisms, which pass and block the light by a member other than the opaque member 27, are also applied properly to the incidence switcher 20B. Any of the optional modes described herein permit producing the same operations and advantages as those of the Embodiment.

Above-described example comprises the liquid-crystal shutter 23 switching between the incidence state and the non-incidence state over the entire face as show in Fig.1 ; the Embodiment comprises the opaque member 27 formed as the fan-shaped configuration as shown in Fig. 8. The example and the Embodiment thus constructed produce the output current "Iout" and output voltage "Vout" having waveforms as shown in Figs. 4 and 5. The resulting waveforms are different from those of sine waves, or from those of cosine waves as well, which will likewise hold true hereinafter. Instead of the modes, the liquid-crystal shutter 23 is satisfactorily constructed so that it carries out the passing/blocking control to partially switch the light falling on the charge separation layer 32 between the incident state and the non-incident state. Alternatively, the opaque member 27 is properly constructed so as to have a configuration which partially switches the light between the incident state and the non-incident state. The phrase, "partially switch," implies controlling the liquid-crystal shutter 23, or providing the opaque member 27 with a configuration, so as to make the light transmit through the liquid-crystal shutter 23 or opaque member 23 to fall on the charge separation layer 32 with a sequentially increasing transmittance of from 0% to 100% or conversely with a decreasing transmittance of from 100% to 0%. The liquid-crystal shutter 23 controlled adequately, or the opaque member 27 formed as an adequate configuration, enables the output current "Iout" and output voltage "Vout, "which are output from the first electrode 31 and second electrode 34 serving as the output terminals, to exhibit a sine wave as shown in Fig. 10. Although not shown in the drawing, it is possible to suitably set up the control for the liquid-crystal shutter 23 or the configuration for the opaque member 23 so as to make the output current "Iout" and output voltage "Vout" exhibit waveforms other than the sine wave, such as rectangular waves, triangular waves, and saw-tooth waves. The thus constructed liquid-crystal shutter 23 and opaque member 27 allow outputting the output current "Iout" and output voltage "Vout" with a targeted waveform, and permit producing the same operations and advantageous effects as those of First and Second Embodiments.

Above-described example and Embodiment comprise the photoelectric conversion element 30 including the insulative polarizer layer 33 which is composed of the ionic liquid accounting for a predetermined volume of the insulative polarizer layer 33 (see Fig. 3). Instead of the mode, the insulative polarizer layer 33 satisfactorily further includes a liquid increment/decrement controller for increasing/decreasing a volume of the ionic liquid contained in the insulative polarizer layer 33. That is, the insulative polarizer layer 33 includes the ionic liquid, a container made of insulator and holding the ionic liquid therein, and a liquid increment/decrement controller for increasing/decreasing a volume of the ionic liquid coming to and from the container. As the volume of the ionic liquid increases/decreases, the container also exhibits an increasing/decreasing electrostatic capacitance. Hence, controlling the volume of the ionic liquid contained within the container allows controlling the output current "Iout" and output voltage "Vout" at predetermined targeted values.

Above-described example comprises the incidence switcher 20A including the liquid-crystal shutter 23, and the photoelectric conversion element 30; and the liquid-crystal shutter 23 and photoelectric conversion element 30 are constructed independently of one another (see Figs. 1 through 3). Instead of the mode, sharing the electrodes of the liquid-crystal shutter 23 with those of the photoelectric conversion element 30 satisfactorily constructs the liquid-crystal shutter 23 and photoelectric conversion element 30 so that they are formed integrally with one another. The shared electrodes make an identical potential with one another. Hence, one of the shared electrodes is desirably earthed to the ground potential "GND" when a voltage for driving the liquid-crystal shutter 23 differs from an electromotive force produced by the photoelectric conversion element 30. The thus constructed liquid-crystal shutter 23 and photoelectric conversion element 30 make the photoelectric conversion apparatus 10 that is integrated, allowing downsizing as well as producing the same operations and advantageous effects as those of the example.

### (Operations and Advantageous Effects)

Each of above-described example and Embodiment, as well as each of the other embodiments, produces advantageous effects as described below.
(1) The photoelectric conversion apparatus 10 (e.g., 10A or 10B) is constructed to comprise: a pair of electrodes including the first electrode 31 and the second electrode 34 each of which makes an output terminal; the charge separation layer 32 (i.e., a charge separator) disposed to make contact with the first electrode 31, and subjected to a light to separate a charge; the insulative polarizer layer 33 (i.e., an insulative polarizer) disposed to intervene between the charge separation layer 32 and the second electrode 34, insulating the first electrode 31 and the charge separation layer 32 from the second electrode 34, and producing polarization; and the incidence switcher 20 (e.g., 20A or 20B) alternately switching between an incident state where the light falls on the charge separation layer 32, and a non-incident state where the light does not fall on the charge separation layer 32, based on an electromotive force arising between the first electrode 31 and the second electrode 34; the charge separation layer 32 separating the charge, the insulative polarizer layer 33 storing and discharging the separated charge, and the incidence switcher 20 switching between the incident state and the non-incident state making the photoelectric conversion apparatus 10 self-oscillate to sustainably output an alternating current or alternating voltage from the output terminals (see Figs. 1, 7 and 8). The thus constructed photoelectric conversion apparatus 10 flows an electric current from one of the electrodes (e.g., the first electrode 31) to the other one of the electrodes (e.g., the second electrodes 34) in the incidence state, and flows the electric current from the other of the electrodes to the one of the electrodes in the non-incidence state. The incidence switcher 20 alternately switches between the incidence state and the non-incidence state. The combined operations of the charge separation layer 32, insulative polarizer layer 33 and incidence switcher 20 make the photoelectric conversion apparatus 10 self-oscillate to sustainably output an alternating current or alternating voltage from the output terminals (i.e., the first electrode 31 and second electrode 34). Moreover, the incidence switcher 20, which alternately changes between the incident state and the non-incident state based on the electromotive force arising between the first electrode 31 and the second electrode 34, enables electric energy output from the output terminals to alternate.
(2) The photoelectric conversion apparatus 10 is constructed to provide a predetermined time lag between a change in the electromotive force and the switching between the incident state and the non-incident state by the incidence switcher 20. The thus constructed photoelectric conversion apparatus 10 allows the output of the alternating current or alternating voltage from the output terminals to self-oscillate, and permits the output to be sustainable.
(3) The photoelectric conversion apparatus 10 is constructed to comprise the charge separation layer 32 including one or more members selected from the group consisting of organic compounds, inorganic compounds and metallic complexes, which are capable of separating a charge when they are subjected to the light. The thus constructed photoelectric conversion apparatus 10 allows composing the charge separation layer 32 of a material being capable of reliably carrying out electric power generation.
(4) The charge separation layer 32 is constructed to include one or both members selected from the group consisting of a donor and an acceptor, which have a charge-transfer absorption band. The thus constructed charge separation layer 32 allows composing the charge separation layer 32 of a material being in compliance with a wavelength region of the incident light.
(5) The charge separation layer 32 is constructed to include a compound having a perovskite crystalline structure. The thus constructed charge separation layer 32 allows carrying out electric power generation at low cost and highly efficiently, and permits enhancing the output current "Iout" (i.e., the alternating current) and output voltage "Vout" (i.e., the alternating voltage).
(6) The charge polarizer layer 33 is constructed to include an ionic liquid whose major components are a positive ion and a negative ion. The thus constructed charge polarizer layer 33 forms an electric double layer, which facilitates a charge separation and makes a large power-generating capacity obtainable, at an interface between itself and the charge separation layer 32.
(7) The ionic liquid is constructed to shows a plastic crystalline phase. The thus constructed ionic liquid allows ions included in the ionic liquid to move freely, and permits preventing the ionic liquid from leaking to the outside from out of the photoelectric conversion element 30.
(8) The incidence switcher 20 is constructed to include an opaque member and a movement mechanism moving the opaque member 27 so as to pass between a source of the light and the photoelectric conversion element 30 to be capable of alternately changing between transmission and shutoff of the light (see Figs. 1, 7 and 8). The thus constructed incidence switcher 20, which alternately switches between the incident state and the non-incident state surely, allows making electric energy, which is output from the output terminals (i.e., the first electrode 31 and second electrode 34), sustainable reliably.

### Industrial Applicability

The present invention provides a photoelectric conversion apparatus self-oscillating to make possible a sustainable conversion from light energy into alternating electric energy.

### Explanation on Reference Numerals

10 (e.g., 10A, or 10B) : Photoelectric Conversion Apparatus;
20 (e.g., 20A, 20B): Incidence Switcher;
21: Amplifier;
22: Signal Generator;
23: Liquid-crystal Shutter;
24: Rectifier;
25: Inverter;
26: Motor;
27: Opaque Member;
30: Photoelectric Conversion Element;
31: First Electrode (or Output Terminal);
32: Charge Separation Layer (or Charge Separator);
33: Insulative Polarizer Layer (or Insulative Polarizer);
34: Second Electrode (or Another Output Terminal)

## Claims

1. A photoelectric conversion apparatus (10, 10B) for converting light energy into electric energy and then outputting the electric energy, the photoelectric conversion apparatus comprising:
a pair of electrodes (31, 34) including a first electrode (31) and a second electrode (34) each of which makes an output terminal for outputting the electric energy;
a charge separator (32) disposed to make contact with the first electrode (31) and, if subjected to a light, to separate a charge;
an insulative polarizer (33) disposed to intervene between the charge separator (32) and the second electrode (34), insulating the first electrode and the charge separator from the second electrode, and configured to produce polarization if the charge separator is subjected to the light, the insulative polarizer being configured to store and discharge the separated charge;
**characterized in that** the photoelectric conversion apparatus (10, 10B) further comprises
an incidence switcher (20, 20B) configured to alternately switch between an incident state where, if the light is incident in a direction towards the charge separator, the light falls on the charge separator, and a non-incident state where, if the light is incident in a direction towards the charge separator, the light does not fall on the charge separator, based on an electromotive force between the first electrode and the second electrode, making the photoelectric conversion apparatus self-oscillate to sustainably output an alternating current or alternating voltage from the output terminals if the light is incident in a direction towards the charge separator, wherein
the incidence switcher includes an opaque member (27) and a movement mechanism configured to move the opaque member so as to pass the opaque member between a source of the light and the charge separator to be capable of alternately changing between transmission and shutoff of the light;
the incidence switcher is configured to switch from the incident state to the non-incident state after lapse of a first predetermined time lag after the charge separator starts to produce the polarization when the light is incident in a direction towards the charge separator and the light falls on the charge separator in the incident state,
a first switching time for switching from the incident state to the non-incident state is equal to or shorter than the first predetermined time lag;
the incidence switcher is configured to switch from the non-incident state to the incident state after lapse of a second predetermined time lag after the charge separator stops to produce the polarization when the light does not fall on the charge separator in the non-incident state;
a second switching time for switching from the non-incident state to the incident state is equal to or shorter than the second predetermined time lag.

2. The photoelectric conversion apparatus (10, 10B) as set forth in claim 1, wherein the charge separator (32) includes one or more members selected from the group consisting of organic compounds, inorganic compounds and metallic complexes, which are is configured to separate a charge when they are subjected to the light.

3. The photoelectric conversion apparatus (10, 10B) as set forth in any one of claims 1 through 2 , wherein the charge separator (32) includes one or more members selected from the group consisting of a donor and an acceptor, which have a charge-transfer absorption band.

4. The photoelectric conversion apparatus (10,10B) as set forth in any one of claims 1 through 3, wherein the charge separator (32) includes a compound having a perovskite crystalline structure.

5. The photoelectric conversion apparatus (10,10B) as set forth in any one of claims 1 through 4, wherein the insulative polarizer (33) includes an ionic liquid whose major components are a positive ion and a negative ion.

6. The photoelectric conversion apparatus (10,10B) as set forth in claim 5, wherein the ionic liquid exhibits a plastic crystalline phase.

## Patentansprüche

1. Photoelektrische Umwandlungsvorrichtung (10, 10B) zum Umwandeln von Lichtenergie in elektrische Energie und zur anschließenden Abgabe der elektrischen Energie, wobei die photoelektrische Umwandlungsvorrichtung umfasst:
ein Elektrodenpaar (31, 34) mit einer ersten Elektrode (31) und einer zweiten Elektrode (34), von denen jede einen Ausgangsanschluss zur Abgabe der elektrischen Energie bildet;
einen Ladungstrenner (32), der so angeordnet ist, dass er mit der ersten Elektrode (31) in Kontakt kommt und, wenn er Licht ausgesetzt ist, eine Ladung trennt;
einen isolierenden Polarisator (33), der so angeordnet ist, dass er zwischen dem Ladungstrenner (32) und der zweiten Elektrode (34) interveniert, wobei er die erste Elektrode und den Ladungstrenner von der zweiten Elektrode isoliert, und konfiguriert ist, um eine Polarisation zu erzeugen, wenn der Ladungstrenner dem Licht ausgesetzt ist, wobei der isolierende Polarisator konfiguriert ist, um die getrennte Ladung zu speichern und abzuführen;
**dadurch gekennzeichnet, dass** die photoelektrische Umwandlungsvorrichtung (10, 10B) ferner Folgendes umfasst
einen Lichteinfallsschalter (20, 20B), der konfiguriert ist, um auf der Grundlage einer elektromotorischen Kraft zwischen der ersten Elektrode und der zweiten Elektrode abwechselnd zwischen einem Lichteinfalls-Zustand, in dem, wenn das Licht in einer Richtung zum Ladungstrenner hin einfällt, das Licht auf den Ladungstrenner fällt, und einem Nicht-Lichteinfalls-Zustand, in dem, wenn das Licht in einer Richtung zum Ladungstrenner hin einfällt, das Licht nicht auf den Ladungstrenner fällt, umzuschalten, wodurch die photoelektrische Umwandlungsvorrichtung in Selbstoszillation versetzt wird, um kontinuierlich einen Wechselstrom oder eine Wechselspannung an den Ausgangsanschlüssen auszugeben, wenn das Licht in einer Richtung zum Ladungstrenner hin einfällt, wobei
der Lichteinfallsschalter ein opakes Element (27) und einen Bewegungsmechanismus aufweist, der konfiguriert ist, um das opake Element zu bewegen, so dass das opake Element zwischen eine Lichtquelle und den Ladungstrenner eingebracht wird, um abwechselnd zwischen Durchlassen und Absperren des Lichts wechseln zu können;
der Lichteinfallsschalter konfiguriert ist, um vom Lichteinfalls-Zustand in den Nicht-Lichteinfalls-Zustand nach Ablauf einer ersten vorbestimmten Zeitverzögerung, nachdem der Ladungstrenner beginnt, die Polarisation zu erzeugen, wenn das Licht in einer Richtung zu dem Ladungstrenner hin einfällt und das Licht im Lichteinfalls-Zustand auf den Ladungstrenner fällt, umzuschalten,
eine erste Schaltzeit für das Umschalten vom Lichteinfalls-Zustand in den Nicht-Lichteinfalls-Zustand gleich oder kürzer als die erste vorbestimmte Zeitverzögerung ist;
der Lichteinfallsschalter konfiguriert ist, um vom Nicht-Lichteinfalls-Zustand in den Lichteinfalls-Zustand nach Ablauf einer zweiten vorbestimmten Zeitverzögerung, nachdem der Ladungstrenner aufhört, die Polarisation zu erzeugen, wenn das Licht im Nicht-Lichteinfalls-Zustand nicht auf den Ladungstrenner fällt, umzuschalten;
eine zweite Schaltzeit für das Umschalten von dem Nicht-Lichteinfalls-Zustand in den Lichteinfalls-Zustand gleich oder kürzer als die zweite vorbestimmte Zeitverzögerung ist.

2. Photoelektrische Umwandlungsvorrichtung (10, 10B) nach Anspruch 1, wobei der Ladungstrenner (32) ein oder mehrere Elemente aufweist, die aus der Gruppe ausgewählt sind, die aus organischen Verbindungen, anorganischen Verbindungen und Metallkomplexen besteht, die konfiguriert sind, um eine Ladung zu trennen, wenn sie dem Licht ausgesetzt sind.

3. Photoelektrische Umwandlungsvorrichtung (10, 10B) nach einem der Ansprüche 1 bis 2, wobei der Ladungstrenner (32) ein oder mehrere Elemente aufweist, die aus der Gruppe ausgewählt sind, die aus einem Donor und einem Akzeptor besteht, die ein Ladungstransfer-Absorptionsband aufweisen.

4. Photoelektrische Umwandlungsvorrichtung (10, 10B) nach einem der Ansprüche 1 bis 3, wobei der Ladungstrenner (32) eine Verbindung mit einer Perowskit-Kristallstruktur aufweist.

5. Photoelektrische Umwandlungsvorrichtung (10, 10B) nach einem der Ansprüche 1 bis 4, wobei der isolierende Polarisator (33) eine ionische Flüssigkeit enthält, deren Hauptbestandteile ein positives Ion und ein negatives Ion sind.

6. Photoelektrische Umwandlungsvorrichtung (10, 10B) nach Anspruch 5, wobei die ionische Flüssigkeit eine plastische kristalline Phase aufweist.

## Revendications

1. Appareil de conversion photoélectrique (10, 10B) pour convertir l'énergie lumineuse en énergie électrique et puis sortir l'énergie électrique, l'appareil de conversion photoélectrique comprenant :
une paire d'électrodes (31, 34) comprenant une première électrode (31) et une seconde électrode (34) dont chacune constitue une borne de sortie pour la sortie de l'énergie électrique ;
un séparateur de charge (32) disposé de manière à entrer en contact avec la première électrode (31) et, s'il est soumis à une lumière, à séparer une charge ;
un polariseur isolant (33) disposé pour intervenir entre le séparateur de charge (32) et la seconde électrode (34), isolant la première électrode et le séparateur de charge de la seconde électrode, et configuré pour produire une polarisation si le séparateur de charge est soumis à la lumière, le polariseur isolant étant configuré pour stocker et décharger la charge séparée ;
**caractérisé en ce que** l'appareil de conversion photoélectrique (10, 10B) comprend en outre
un commutateur d'incidence (20, 20B) configuré pour commuter alternativement, sur la base d'une force électromotrice entre la première électrode et la seconde électrode, entre un état d'incidence dans lequel, si la lumière est incidente dans une direction vers le séparateur de charge, la lumière tombe sur le séparateur de charge, et un état de non-incidence dans lequel, si la lumière est incidente dans une direction vers le séparateur de charge, la lumière ne tombe pas sur le séparateur de charge ce qui fait auto-osciller le dispositif de conversion photoélectrique afin de délivrer en continu un courant alternatif ou une tension alternative aux bornes de sortie si la lumière est incidente dans une direction vers le séparateur de charge, dans lequel
le commutateur d'incidence comprend un élément opaque (27) et un mécanisme de déplacement configuré pour déplacer l'élément opaque soit interposé entre une source de lumière et le séparateur de charge afin de pouvoir alterner entre la transmission et l'arrêt de la lumière ;
le commutateur d'incidence est configuré pour commuter de l'état d'incidence à l'état de non-incidence après l'écoulement d'un premier délai prédéterminé après que le séparateur de charge commence à produire la polarisation lorsque la lumière est incidente dans une direction vers le séparateur de charge et que la lumière tombe sur le séparateur de charge à l'état d'incidence,
un premier temps de commutation pour commuter de l'état d'incidence à l'état de non-incidence est égal ou inférieur au premier délai prédéterminé ;
le commutateur d'incidence est configuré pour commuter de l'état de non-incidence à l'état d'incidence après l'écoulement d'un second délai prédéterminé après que le séparateur de charge cesse de produire la polarisation lorsque la lumière ne tombe pas sur le séparateur de charge dans l'état de non-incidence ;
un second temps de commutation pour commuter de l'état de non-incidence à l'état d'incidence est égal ou inférieur au second délai prédéterminé.

2. Appareil de conversion photoélectrique (10, 10B) selon la revendication 1, dans lequel le séparateur de charge (32) comprend un ou plusieurs éléments choisis dans le groupe constitué par des composés organiques, des composés inorganiques et des complexes métalliques, qui sont configurés pour séparer une charge lorsqu'ils sont soumis à la lumière.

3. Appareil de conversion photoélectrique (10, 10B) selon l'une des revendications 1 à 2, dans lequel le séparateur de charge (32) comprend un ou plusieurs éléments choisis dans le groupe constitué par un donneur et un accepteur, qui ont une bande d'absorption de transfert de charge.

4. Appareil de conversion photoélectrique (10, 10B) selon l'une des revendications 1 à 3, dans lequel le séparateur de charge (32) comprend un composé ayant une structure cristalline de pérovskite.

5. Appareil de conversion photoélectrique (10, 10B) selon l'une des revendications 1 à 4, dans lequel le polariseur isolant (33) comprend un liquide ionique dont les composants principaux sont un ion positif et un ion négatif.

6. Appareil de conversion photoélectrique (10, 10B) selon la revendication 5, dans lequel le liquide ionique présente une phase cristalline plastique.
